# EUROPÄISCHE PATENTSCHRIFT

(11) **EP 2 872 665 B1**
(45) Veröffentlichungstag und Bekanntmachung des Hinweises auf die Patenterteilung: **29.11.2023**
(21) Anmeldenummer: 13732096.6
(22) Anmeldetag: 24.06.2013
(51) Int. Cl.: C23C 14/34, H01J 37/34

(54) **HOCHLEISTUNGSIMPULSBESCHICHTUNGSMETHODE**
HIGH-POWER PULSE COATING METHOD
PROCÉDÉ DE REVÊTEMENT PAR IMPULSION HAUTE PUISSANCE

(30) Priorität: 10.07.2012 DE 102012013577
(43) Veröffentlichungstag der Anmeldung: 20.05.2015
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); KURAPOV, Denis, CH-8880 Walenstradt (CH)
(74) Vertreter: Kempkens, Anke
(86) Internationale Anmeldenummer: PCT/EP2013/001853
(87) Internationale Veröffentlichungsnummer: WO 2014/008984

(56) Entgegenhaltungen:
- DE-A1-102008 021 912
- DE-U1-202009 018 428
- US-A1- 2009 173 622
- BOUZAKIS K D ET AL: "Adaption of graded Cr/CrN-interlayer thickness to cemented carbide substrates' roughness for improving the adhesion of HPPMS PVD films and the cutting performance", SURFACE AND COATINGS TECHNOLOGY, ELSEVIER, AMSTERDAM, NL, Bd. 205, Nr. 5, 25. November 2010 (2010-11-25), Seiten 1564-1570, XP027507526, ISSN: 0257-8972, DOI: 10.1016/J.SURFCOAT.2010.09.010 [gefunden am 2010-11-19]
- STRANAK VITEZSLAV ET AL: "Time-resolved investigation of dual high power impulse magnetron sputtering with closed magnetic field during deposition of Tiâ Cu thin films", JOURNAL OF APPLIED PHYSICS, AMERICAN INSTITUTE OF PHYSICS. NEW YORK, US, Bd. 108, Nr. 4, 19. August 2010 (2010-08-19), Seiten 43305-43305, XP012142609, ISSN: 0021-8979, DOI: 10.1063/1.3467001
- J T Gudmundsson ET AL: "High power impulse magnetron sputtering discharge", Journal of Vacuum Science & Technology A (Vacuum, Surfaces, and Films), 14 March 2012 (2012-03-14), page 030801 (35 pp.), XP055030718, DOI: 10.1116/1.3691832] Retrieved from the Internet: URL:http://avs.scitation.org/doi/pdf/10.11 16/1.3691832 [retrieved on 2012-06-22]

## Beschreibung

Die vorliegende Erfindung bezieht sich auf ein Verfahren zur Aufbringung einer Mischkristallschicht mittel High Power Impuls Sputtering (HIPIMS), unter Verwendung von mindestens zwei Targets mit unterschiedlichen Materialien.

Werden gemäss Stand der Technik die Targets zum Abscheiden der Mischkristallschicht gleichzeitig betrieben, so ergibt sich die Problematik dass die unterschiedlichen Targets bei gleichen Prozessparametern unterschiedlich stark vergiften. Beide Targets unabhängig voneinander im jeweils gewünschten Arbeitsmodus zu halten ist dabei nicht möglich, da die Sputterquellen über das Volumen mit demselben Partialdruck des Reaktivgases verbunden sind.

Im Rahmen der vorliegenden Beschreibung werden die Begriffe "zerstäuben" und "sputtern" als identisch verstanden. Als Target wird im Rahmen der vorliegenden Beschreibung derjenige Bestandteil einer Sputterquelle bezeichnet, von welchem während des Verfahrens Material abgetragen wird.

Um Mischkristalle herzustellen werden in der Sputtertechnologie gemäss Stand der Technik Composite Targets (Verbund-Targets) eingesetzt. So ist in der DE60104709 ein Target bestehend aus einem ersten Grundmaterial und einem zweiten Material beschrieben, welches in Form von stopfen in das erste grundmaterial eingebracht ist. Eine weitere Methode zur Herstellung von Verbundtargets ist die Pressung im Pulvermetallurgischen Verfahren von zwei oder mehreren metallischen Pulvern mit Korngrössen unter 100µm.

Ein Nachteil ist dabei, dass zu Realisation unterschiedliche Konzentrationsverhältnisse in der Mischkristallschicht jeweils andere Targets eingesetzt werden müssen. Hinzu kommt das bei Schichten die derartigen Targettypen hergestellt werden die Schichtkomposition nicht mit der Ausgangskomposition des Targetmaterials übereinstimmt.

Im Stand der Technik wird gemäss einem anderen Ansatz vorgeschlagen zumindest ein Material mittels Dual Magnetron oder HIPIMS und zumindest ein zweites Material mittels Lichtbogenverdampfen gleichzeitig zu betreiben. Dementsprechend wird in der WO2011/138331 ein Verfahren zum Abscheiden von Mischkristallschichten mit wenigstens zwei verschiedenen Metallen (M1, M2) auf einem Substrat mittels PVD-Verfahren offenbart, welches dadurch gekennzeichnet ist, dass das Abscheiden der Mischkristallschicht unter gleichzeitiger Anwendung i) der Kathodenzerstäubungsverfahrens duales Magnetronsputtern oder High Power Impulse Magnetronsputtern (HIPIMS) und ii) Lichtbogenverdampfen (Arc-PVD) durchgeführt wird.

Dabei ist von Nachteil, dass aufgrund der zwei PVD-Verfahren zwei aufwändige Technologien in einer Beschichtungskammer realisiert werden müssen. Ausserdem ergeben sich in der Mischkristallschicht aufgrund des Lichtbogenverfahrens Spritzer (Droplets) welche die Schichteigenschaften wie zum Beispiel die Schichtrauhigkeit negativ beeinflussen.

Aus dem Stand der Technik sind auch folgende Ergebnisse bekannt:
- In der Arbeit "Adaption of graded Cr/CrN-interlayer thickness to cemented carbide substrates' roughness for improving the adhesion of HPPMS PVD films and the cutting performance", veröffentlicht in der Zeitschrift SURFACE AND COATINGS TECHNOLOGY 205 (2010)1564-1570, beschreiben Bouzakis et.al die Verwendung der HiPIMS Technologie für das Betreiben von zwei Targets aus unterschiedlichen Materialien, jedoch nicht um eine Mischkristallschicht zu produzieren, sondern um eine Beschichtung mit zwei unterschiedlichen Schichten aufzubringen, wobei ein erstes Target aus einem ersten Material für die Abscheidung einer ersten Schicht und anschliessend ein zweites Target aus einem zweiten Material für die Abscheidung einer zweiten Schicht verwendet werden.
- In der Arbeit "Time-resolved investigation of dual high power impulse magnetron sputtering with closed magnetic field during deposition of Ti-Cu thin films", veröffentlicht in der Zeitschrift JOURNAL OF APPLIED PHYSICS 108. 043305 (2010), beschreiben Stranak et.al die Verwendung von zwei Targets, jeweils aus Ti und Cu für die Abscheidung einer Beschichtung mittels HiPIMS, wobei das Ti-Target und das Cu-Target derart alternierend betrieben werden, dass zwischen dem Betreiben des Ti-Targets und dem Betreibens des Cu-Targets ein definierter Zeitverzug notwendig ist.
- In der Arbeit "High power impulse magnetron sputtering discharge", veröffentlicht in der Zeitschrift JOURNAL OF VACUUM SCIENCE & TECHNOLOGY A 30(3) 030801 (2012), offenbaren Gudmundsson et.al, dass das Beschichten mittels reaktives HiPIMS im Übergangsmodus die höchste Beschichtungsrate aufweist.

Die Aufgabe der vorliegenden Erfindung besteht darin ein Verfahren anzugeben, mit welchem die oben geschilderten Probleme überwunden werden. Insbesondere soll es mit dem Verfahren möglich sein mittels HIPIMS und ohne Lichtbogenverdampfen eine Mischkristallschicht zu erzeugen. Erfindungsgemäss wird dies dadurch erreicht, dass ein HIPIMS Verfahren gemäss dem Anspruch 1 durchgeführt wird.

Das HiPIMS Verfahren wird unter Verwendung von mindestens zwei Targets mit unterschiedlichen Materialien durchgeführt, wobei der für das Targetmaterial jeweils geeignete Arbeitspunkt über die Leistungspulse bezgl. der Leistung und Pulsdauer getrennt justiert wird.

Für ein besseres Verständnis der komplexen Vorgänge bei einem HIPIMS-Verfahren wird zunächst ein wenig mehr auf die Targetvergiftung eingegangen. Der reaktive Sputtervorgang wird durch die Reaktion der Targetoberfläche mit dem Reaktivgas wie z.B. Stickstoff oder Sauerstoff bestimmt. Dies wird als Targetvergiftung bezeichnet. Bei hohem Vergiftungsgrad der Targetoberfläche und hoher Reaktivität (z.B. Nitrierung oder Oxidation) kommt es zu einer geringen Sputterrate. Wird in diesem Fall die Sputterrate als Funktion des Reaktivgasflusses aufgetragen, so ergibt sich die dem Fachmann bekannte Hysterese.

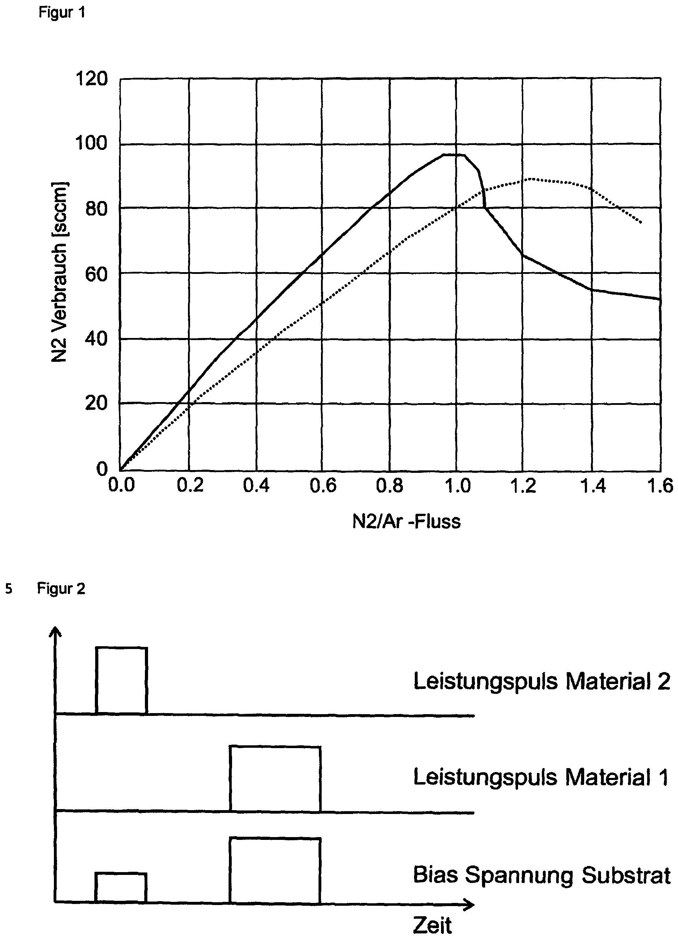

Figur 1 zeigt die Aufnahme von Stickstoff an den reaktiven Oberflächen wie Target und Schicht in Abhängigkeit des Verhältnisses von Stickstofffluss zu Argonfluss für unterschiedliche Pulsdauer. Dabei wurde der mittlere Druck und der Ar-Fluss auch konstant gehalten. Die Pulsleistung betrug 1000W/cm². Die durchgezogene Linie bezieht sich auf eine Pulsdauer von 50µs und die gepunktete Linie bezieht sich auf eine Pulsdauer von 2000µs.

Die Kennlinie eines HIPIMS Prozesses mit einer Pulsdauer von 50µs zeigt bei Zugabe von Stickstoff ein vollständiges Aufzehren des eingebrachten Stickstoffes bis zu einem N2/Ar - Fluss Verhältnis von ca. 0.9. Die Stickstoffkonsumation ist in etwa proportional zur Beschichtungsrate. Ab einem Verhältnis von 1.0 und höher sinkt die Sputterrate durch die Nitrierung der Target Oberfläche stark ab. Dieser Bereich wird Übergangsbereich genannt. Er markiert den Bereich des Übergangs zu einer vergifteten Targetoberfläche. Bei weiterer Zugabe von Stickstoff nimmt die Vergiftung der Target Oberfläche zu und die Rate nähert sich einem Minimalwert.

Wird die oben genannte HIPIMS Entladung mit einer Pulsdauer von 2000µs bei sonst gleicher mittlerer Sputterleistung betrieben, so verschiebt sich der Bereich des Übergangs zu einer vergifteten Targetoberfläche hin zu höheren N2/Ar -Fluss Verhältnissen. Dies bedeutet aber, dass bei vorgegebenem N2/Ar-Fluss Verhältnis mittels Wahl der Pulsdauer eingestellt werden kann, ob mit einem Target im metallischen Modus, im vergifteten Modus oder im Übergangsbereich zerstäubt wird. D.h. mittels Pulsdauerwahl kann der Arbeitspunkt eingestellt werden. Dies eröffnet die Möglichkeit bei zwei oder mehreren Targets mit unterschiedlichen Materialien und damit unterschiedlichem Reaktionsverhalten gegenüber dem Sputtergas durch eine dem jeweiligen Targetmaterial zugeordnete Pulsdauer unabhängig voneinander in ihrem Arbeitspunkt einzustellen.

Es sei darauf hingewiesen, dass beim Pulsen mit moderaten Leistungsdichten, wie sie beim herkömmlichen Sputterverfahren eingesetzt werden. die oben beschriebene Abhängigkeit von der Pulsdauer nicht auftritt.

Figur 1 zeigt insbesondere, dass wenn der Arbeitspunkt bei einer Einstellung des Verhältnisses Reaktivgas zu Inertgas von 1.2 festgelegt wird, der HIPIMS Sputterprozess unter Verwendung einer Pulsdauer von 50µs bereits im vergifteten Modus läuft und die Beschichtungsrate um ca 30% geringer ist als die maximal erzielbare Beschichtungsrate im Übergangsbereich. Durch die Erhöhung der Pulsdauer des HIPIMS Leistungspulses bei ansonsten gleichbleibender mittlerer Sputterleistung und gleichen Prozessgas-Bedingungen liegt der mit einem Reaktivgas zu Inertgasverhältnis von 1.2 gewählte Arbeitspunkt wieder im Übergangsbereich.

Die Erfinder vermuten, dass im Rahmen des HIPIMS-Verfahrens das Energiequantum pro Leistungspuls die massgebende Rolle spielt, welches sich aus dem Produkt von Pulsleistungsamplitude und Pulsdauer ergibt. Auch die Anzahl der Pulse pro Zeiteinheit kann dabei eine Rolle spielen.

Die Erfindung wird nun im Detail anhand mehrerer Ausführungsformen beispielhaft und anhand der Figuren beschrieben.
Figur 1 zeigt den Stickstoffverbrauch in Abhängigkeit des Verhältnisses des Reaktivgas/Inertgas-Flusses für unterschiedliche Pulsdauer
Figur 2 zeigt den auf die Leistungspulse synchronisierten Substratbias
Figur 3 zeigt schematisch eine Beschichtungsanlage

Eine Beschichtungskammer in der ein erfindungsgemässes HIPIMS-Verfahren angewandt werden soll umfasst eine erste Sputterquelle Q1 mit einem ersten Target TA1 aus einem ersten zu zerstäubenden Targetmaterial und eine zweite Sputterquelle Q2 mit einem zweiten Target TA2 aus einem zweiten Targetmaterial. Im Beispiel kann das erste Target TA1 aus Aluminium und das zweite Target TA2 aus Chrom bestehen. Gemäss einer ersten Ausführungsform der vorliegenden Erfindung wird Argon und Stickstoff im Verhältnis 1:1 in die zuvor evakuierte Beschichtungskammer eingelassen. Damit erfahren die Targetoberflächen denselben Reaktiv- und Inertgas Partialdruck. Die an den Targets anliegende Leistungsdichte in den Pulsen wird auf 1000W/cm² festgelegt. Die Pulsdauern (t1, t2) wird individuell pro Target so festgelegt, dass der Arbeitspunkt jeweils im Übergangsbereich liegt. Der Füllfaktor D, d.h. das Verhältnis zwischen Pulsdauer und Wiederholintervall (= Zeitintervall vom Anfang eines Pulses an einem Target bis zum Anfang des nächsten Pulses am selben Target) wird für beide Targets gleich gewählt. Damit ergibt sich eine an den Targets anliegende unterschiedliche mittlere Leistung. Aufgrund der hohen Leistungsdichte kommt es zu einem hohen ionisierten Anteil des zerstäubten Materials. Wird an die zu beschichtenden Substrate ein negativer Bias angelegt, so führt dies zu dichten, glatten Schichten.

Gemäss eine zweiten Ausführungsform der vorliegenden Erfindung werden anders als gemäss der ersten Ausführungsform die an den Targets anliegenden Leistungsdichten und/oder die Füllfaktoren individuell eingestellt.

Wie dem Fachmann unschwer erkennbar spielt bei dem erfindungsgemässen Verfahren die Möglichkeit der kontrollierten Bereitstellung von Pulsen hoher Leistungsdichte mit vorgegebenem Pulsprofil eine wichtige Rolle. Sofern es die Leistungsquelle gestattet, können die Pulse an den Targets völlig unabhängig vom jeweils anderen Target angelegt werden. Dies insbesondere dann, wenn jedem Target eine separate Leistungsquelle zugeordnet ist. Dabei können leistungsstarke DC-Generatoren verwendet werden, die für die Pulsdauer ihre Leistung an das jeweils zugeordnete Target abgeben, für die restliche Zeit ihre Leistung an eine sogenannte Leistungssenke (im Folgenden Dummy Load genannt) abgeben. Die Leistungsabgabe an ein Dummy Load macht besonders beim Beginn der Leistungsabgabe Sinn, da diese einer durch den Generator bestimmten Aufbaucharakteristik folgt. Die Verwendung mehrerer Generatoren hat den Nachteil, dass ein Grossteil der Leistung, nämlich derjenige Teil, welcher auf die Dummy Loads gelenkt wird, schlichtweg nicht genutzt wird

Gemäss einem neuen Verfahren kann hierzu beispielsweise ein leistungsstarker DC-Generator verwendet werden, dessen Leistung mithilfe von Schaltern sequenziell und bevorzugt ohne Unterbrechung der Leistungsabgabe auf die unterschiedlichen Targets appliziert wird. Am Ender des Pulsinterwals wird die Leistung dann einfach auf das Target umgeschalten. Wiederum kann es sinnvoll sein die anfangs und/oder zwischenzeitlich auch auf einen Targetersatz (Dummy Load) umzulenken. Der Leistungsverlust an der Dummy Load ist aber dadurch, dass sequenziell mehrere Targets beaufschlagt werden sehr stark reduziert.

Werden die Targets sequenziell mit Leistungspulsen beaufschlagt so besteht die Möglichkeit gemäss einer besonders bevorzugten Ausführungsform den an die Substrate angelegten Bias mit der Pulsfolge zu synchronisieren und individuell für ein Target und damit für ein Schichtmaterial einen spezifisch gewählten Substratspannungspuls anzulegen. Somit kann beispielsweise für Targetmaterial 1 eine andere Substratbiasspannung und damit Beschleunigung der Ionen erfolgen als für Targetmaterial 2. Die entsprechende Situation ist in Figur 2 dargestellt.

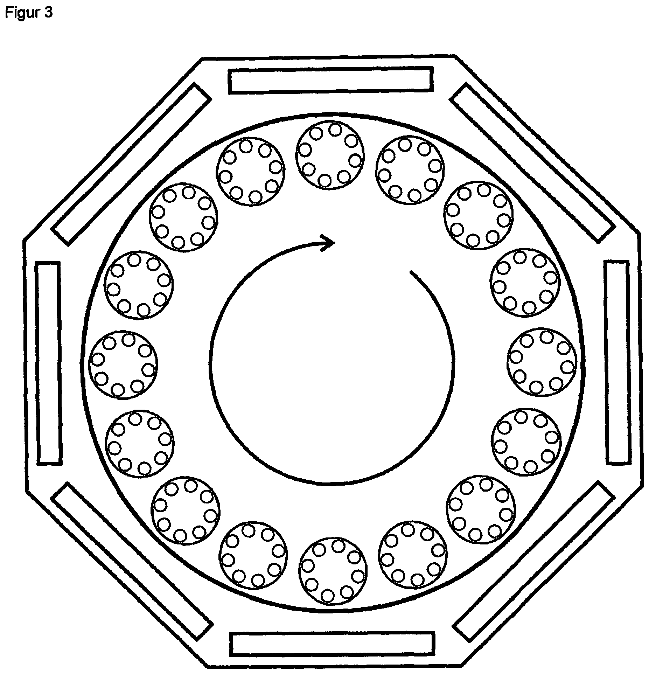

Häufig sind Beschichtungsanlagen als Batchanlagen ausgeführt, in der an den Kammerwänden die verschiedenen Beschichtungsquellen angeordnet sind. Die zu beschichtenden Substrate werden dann in einem sogenannten Karussell in Werkstückträgern angeordnet und aufgrund der Rotation des Karussells periodisch an den Beschichtungsquellen vorbei geführt. Eine dementsprechende Situation ist beispielhaft und schematisch in Figur 3 dargestellt. Mit einem solchen Aufbau kann es vorkommen, dass die dabei entstehende Schicht nicht als homogener Mischkristall abgeschieden wird sondern isogenannte Nanolagen entstehen wobei sich von einer Nanolage zu den benachbarten die Schichtzusammensetzung ändert. Da sich, wie oben diskutiert, über die Pulslänge die Beschichtungsrate targetindividuell einstellen lässt, können erfindungsgemäss in einfacher Weise die dicken der unterschiedlichen Nanolagen relativ zueinander eingestellt werden.

## Patentansprüche

1. Verfahren zur Beschichtung von Substraten mit zu beschichtenden Substratoberflächen mittels Zerstäubung von Targetmaterial wobei folgende Schritte umfasst sind:
- In einer Beschichtungskammer Beaufschlagen eines an einer Beschichtungsquelle angeordneten ersten Sputtertargets aus einem ersten Material mit einem Leistungspuls mittels dem während eines ersten Zeitintervalls eine erste Energiemenge auf das Sputtertarget übertragen wird, wobei dabei die maximale Leistungsdichte 50W/cm² übersteigt
- In der Beschichtungskammer Beaufschlagen eines an einer weiteren Beschichtungsquelle angeordneten zweiten Sputtertargets aus einem zweiten, vom ersten verschiedenen Material mit einem Leistungspuls mittels dem während eines zweiten Zeitintervalls eine zweite Energiemenge auf das Sputtertarget übertragen wird, wobei dabei die maximale Leistungsdichte 50W/cm² übersteigt
**dadurch gekennzeichnet, dass** für die Abscheidung einer Mischkristallschicht ein Reaktivgas in die Beschichtungskammer eingelassen wird und durch die Reaktion vom Material aus dem ersten Sputtertarget und vom Material aus dem zweiten Sputtertarget mit Reaktivgas die Mischkristallschicht auf die zu beschichtenden Substratoberflächen aufgebracht wird, wobei der für das jeweilige Targetmaterial geeignete Arbeitspunkt durch eine dem jeweiligen Targetmaterial zugeordnete Pulsdauer unabhängig voneinander eingestellt wird und dabei sich die erste Energiemenge von der zweiten Energiemenge unterscheidet, und wobei für die Einstellung der Arbeitspunkte das Verfahren folgende Schritte umfasst:
- Einlassen eines Reaktivgases und eines Inertgases in die zuvor evakuierte Beschichtungskammer und einstellen eines vorgegebenen Flussverhältnisses des Reaktivgas zu dem Inertgas,
- Einstellung des Arbeitspunkts der jeweiligen Targets mittels Wahl der Pulsdauer beim vorgegebenen Flussverhältnis, ob jeweils mit dem Target im metallischen Modus, im vergifteten Modus oder im Übergangsbereich zerstäubt wird,

2. Verfahren nach dem Anspruch 1, **dadurch gekennzeichnet, dass** das vorgegebene Flussverhältnis 1:2 ist.

3. Verfahren nach dem Anspruch 1, **dadurch gekennzeichnet, dass** das vorgegebene Flussverhältnis 1:1 ist.

4. Verfahren nach einem der vorangehenden Ansprüche 1 bis 3, **dadurch gekennzeichnet, dass** die Pulsdauer individuell pro Target so festgelegt wird, dass der Arbeitspunkt jeweils im Übergangsbereich liegt.

5. Verfahren nach einem der vorangehenden Ansprüche 1 bis 4, **dadurch gekennzeichnet, dass** der Füllfaktor, d.h. das Verhältnis zwischen Pulsdauer und Wiederholintervall für beide Targets gleich gewählt wird.

6. Verfahren nach einem der vorangehenden Ansprüche 1 bis 5, **dadurch gekennzeichnet, dass** der Füllfaktor, d.h. das Verhältnis zwischen Pulsdauer und Wiederholintervall für beide Targets individuell gewählt wird.

7. Verfahren nach einem der vorangehenden Ansprüche 1 bis 6, **dadurch gekennzeichnet, dass** die erste und die zweiten Energiemengen auf das Sputtertarget so übertragen werden, dass die maximale Leistungsdichte 500W/cm² übersteigt.

8. Verfahren nach einem der vorangehenden Ansprüche 1 bis 7, **dadurch gekennzeichnet, dass** erstes und zweites Zeitintervall zwischen 10µs und 100ms gewählt wird.

9. Verfahren nach Anspruch 8, **dadurch gekennzeichnet, dass** erstes und zweites Zeitintervall zwischen 50µs und 5ms gewählt wird.

10. Verfahren nach einem der vorangehenden Ansprüche 1 bis 9, **dadurch gekennzeichnet, dass** das erste Material und das zweite Material Elementen aus der Gruppe umfasst, welche gebildet wird durch: Titan, Aluminium, Silizium, Chrom, Bor, Kohlenstoff, sowie die Kombination zweier oder mehrerer dieser Elemente

11. Verfahren nach einem der vorangehenden Ansprüche 1 bis 10, **dadurch gekennzeichnet, dass** an die zu beschichtenden Substrate zumindest zeitweise zu den Leistungspulsen synchron ein Substratbias angelegt wird welcher Targetspezifisch gewählt wird.

12. Verfahren nach einem der vorangehenden Ansprüche 1 bis 11, **dadurch gekennzeichnet, dass** während des Verfahrens Argon als Inertgas und N₂ als Reaktivgas verwendet werden.

13. Verfahren nach einem der vorangehenden Ansprüche 1 bis 12, **dadurch gekennzeichnet, dass** zum Abscheiden der Mischkristallschicht jeweils dem ersten Sputtertarget und dem zweiten Sputtertarget eine separate Leistungsversorgungsgerät zugeordnet ist, das für die Pulsdauer ihre Leistung an das jeweils zugeordnete Target abgibt.

14. Verfahren nach einem der vorangehenden Ansprüche 1 bis 12, **dadurch gekennzeichnet, dass** mindestens der jeweilige Leistungspuls auf das erste und das zweite Sputtertarget mittels eines DC-Leistungsversorgungsgerät mit Hilfe von Schaltern sequenziell und bevorzugt ohne Unterbrechung der Leistungsabgabe appliziert wird.

## Claims

1. Method for coating substrates having substrate surfaces to be coated by sputtering of target material, the method comprising the following steps:
- applying a power pulse to a first sputtering target arranged at a coating source and made of a first material in a coating chamber by which power pulse, during a first time interval, a first amount of energy is transmitted to the sputtering target, wherein the maximum power density exceeds 50W/cm²;
- applying a power pulse to a second sputtering target arranged at a further coating source and made of a second material that is different from the first material in the coating chamber by which power pulse, during a second time interval, a second amount of energy is transmitted to the sputtering target, wherein the maximum power density exceeds 50W/cm²,
**characterized in that** for the deposition of a mixed crystal layer, a reactive gas is admitted into the coating chamber and due to the reaction of the material from the first sputtering target and the material from the second sputtering target with reactive gas, the mixed crystal layer is applied to the substrate surfaces to be coated, wherein the operating point suitable for the respective target material is set independently of one another by a pulse duration assigned to the respective target material and the first amount of energy differs from the second amount of energy, and wherein, for setting the operating points, the method comprises the following steps:
- admitting a reactive gas and an inert gas into the previously evacuated coating chamber and setting a predetermined flow ratio of the reactive gas to the inert gas,
- setting the operating point of the respective targets by selecting the pulse duration at the specified flow ratio, whether the target is atomized in metallic mode, in poisoned mode or in the transition region.

2. The method according to claim 1, **characterized in that** the predetermined flow ratio is 1:2.

3. The method according to claim 1, **characterized in that** the predetermined flow ratio is 1:1.

4. The method according to one of the preceding claims 1 to 3, **characterized in that** the pulse duration is determined individually per target so that the operating point is respectively in the transition zone.

5. The method according to one of the preceding claims 1 to 4, **characterized in that** the fill factor, i.e. the ratio between pulse duration and repeat interval is chosen to be the same for both targets.

6. The method according to one of the preceding claims 1 to 5, **characterized in that** the fill factor, i.e. the ratio between pulse duration and repeat interval is chosen individually for both targets.

7. The method according to one of the preceding claims 1 to 6, **characterized in that** the first and second amounts of energy are transmitted to the sputtering target such that the maximum power density exceeds 500W/cm².

8. The method according to one of the preceding claims 1 to 7, **characterized in that** the first and second time interval are chosen between 10µs and 100ms.

9. The method according to claim 8, **characterized in that** the first and second time interval are chosen between 50µs and 5ms.

10. The method according to one of the preceding claims 1 to 9, **characterized in that** the first material and the second material comprise elements from the group formed by: titanium, aluminum, silicon, chromium, boron, carbon as well as the combination of two or more of these elements.

11. The method according to one of the preceding claims 1 to 10, **characterized in that** at the substrates to be coated, a substrate bias which is selected specifically to the target is applied at least temporarily synchronous with the power pulses.

12. The method according to one of the preceding claims 1 to 11, **characterized in that** during the process Argon is used as inert gas and N₂ is used as reactive gas.

13. The method according to one of the preceding claims 1 to 12, **characterized in that** for depositing the mixed crystal layer, a separate power supply device is assigned respectively to the first sputtering target and the second sputtering target, which power supply device delivers its power to the respective assigned target for the pulse duration.

14. The method according to one of the preceding claims 1 to 12, **characterized in that** at least the respective power pulse is applied sequentially and preferably without interrupting the power output to the first and second sputtering targets by means of a DC power supply device with the aid of switches.

## Revendications

1. Procédé de revêtir des substrats ayant des surfaces de substrat à revêtir par pulvérisation de matériau de cible, le procédé comprenant les étapes suivantes :
- appliquer une impulsion de puissance à une première cible de pulvérisation disposée à une source de revêtement et constituée d'un premier matériau dans une chambre de revêtement, au moyen de l'impulsion de puissance, pendant un premier intervalle de temps, une première quantité d'énergie étant transmise à la cible de pulvérisation, et la densité de puissance maximale dépassant 50 W/cm²;
- appliquer une impulsion de puissance à une seconde cible de pulvérisation disposée à une autre source de revêtement et constituée d'un second matériau qui est différent du premier matériau dans la chambre de revêtement, au moyen de l'impulsion de puissance, pendant un second intervalle de temps, une seconde quantité d'énergie étant transmise à la cible de pulvérisation, et la densité de puissance maximale dépassant 50 W/cm²,
**caractérisé en ce que,** pour déposer une couche de cristaux mixtes, un gaz réactif est admis dans la chambre de revêtement et, en raison de la réaction du matériau provenant de la première cible de pulvérisation et du matériau provenant de la seconde cible de pulvérisation avec le gaz réactif, la couche de cristaux mixtes est appliqué sur les surfaces de substrat à revêtir, le point de fonctionnement approprié pour le matériau de cible respectif étant réglé indépendamment l'un de l'autre par une durée d'impulsion attribuée au matériau de cible respectif et la première quantité d'énergie différant de la deuxième quantité d'énergie, et, pour régler les points de fonctionnement, le procédé comprenant les étapes suivantes :
- admettre un gaz réactif et un gaz inerte dans la chambre de revêtement préalablement évacuée et régler un rapport de débit prédéterminé du gaz réactif par rapport au gaz inerte,
- régler le point de fonctionnement des cibles respectives en sélectionnant la durée d'impulsion au rapport de débit spécifié, que la cible soit atomisée en mode métallique, en mode empoisonné ou dans la région de transition.

2. Le procédé selon la revendication 1, **caractérisé en ce que** le rapport de débit prédéterminé est de 1:2.

3. Le procédé selon la revendication 1, **caractérisé en ce que** le rapport de débit prédéterminé est de 1:1.

4. Le procédé selon l'une des revendications précédentes 1 à 3, **caractérisé en ce que** la durée d'impulsion est déterminée individuellement par cible de manière à ce que le point de fonctionnement soit respectivement dans la zone de transition.

5. Le procédé selon l'une des revendications précédentes 1 à 4, **caractérisé en ce que** le facteur de remplissage, c'est-à-dire le rapport entre la durée d'impulsion et l'intervalle de répétition, est choisi de manière à être le même pour les deux cibles.

6. Le procédé selon l'une des revendications précédentes 1 à 5, **caractérisé en ce que** le facteur de remplissage, c'est-à-dire le rapport entre la durée d'impulsion et l'intervalle de répétition, est choisi individuellement pour les deux cibles.

7. Le procédé selon l'une des revendications précédentes 1 à 6, **caractérisé en ce que** les première et deuxième quantités d'énergie sont transmises à la cible de pulvérisation telle que la densité de puissance maximale dépasse 500W/cm².

8. Le procédé selon l'une des revendications précédentes 1 à 7, **caractérisé en ce que** le premier et le deuxième intervalle de temps sont choisis entre 10µs et 100ms.

9. Le procédé selon la revendication 8, **caractérisé en ce que** le premier et le deuxième intervalle de temps sont choisis entre 50µs et 5ms.

10. Le procédé selon l'une des revendications précédentes 1 à 9, **caractérisé en ce que** le premier matériau et le deuxième matériau comprennent des éléments du groupe formé par: titane, aluminium, silicium, chrome, bore, carbone ainsi que la combinaison de deux ou plusieurs de ces éléments.

11. Le procédé selon l'une des revendications précédentes 1 à 10, **caractérisé en ce qu'**on applique, au moins temporairement de manière synchrone avec les impulsions de puissance, une tension de substrat aux substrats à revêtir qui est sélectionnée spécifiquement pour la cible.

12. Le procédé selon l'une des revendications précédentes 1 à 11, **caractérisé en ce qu'**on utilise de l'Argon comme gaz inerte et du N₂ comme gaz réactif pendant le procédé.

13. Le procédé selon l'une des revendications précédentes 1 à 12, **caractérisé en ce que** pour déposer la couche de cristaux mixtes, on attribue un dispositif d'alimentation séparé à la première cible de pulvérisation et à la deuxième cible de pulvérisation, le dispositif d'alimentation délivrant son énergie à la cible attribué respectivement pendant la durée de l'impulsion.

14. Le procédé selon l'une des revendications précédentes 1 à 12, **caractérisé en ce qu'**au moins l'impulsion de puissance respective est appliquée séquentiellement et de préférence sans interruption de la puissance délivrée à la première et à la deuxième cible de pulvérisation au moyen d'un dispositif d'alimentation en courant continu à l'aide d'interrupteurs.
